# EUROPÄISCHE PATENTSCHRIFT

(11) **EP 0 695 815 B1**
(45) Veröffentlichungstag und Bekanntmachung des Hinweises auf die Patenterteilung: **08.04.1998**
(21) Anmeldenummer: 95102548.5
(22) Anmeldetag: 23.02.1995
(51) Int. Cl.: C23C 14/54, C23C 14/56, C23C 14/00

(54) **Verfahren zum Aufbringen einer transparenten Metalloxidschicht auf einer Folie**
Method for coating a sheet with a transparent metal oxide layer
Procédé de revêtement d'une feuille par une couche d'oxyde métallique transparent

(30) Priorität: 04.08.1994 DE 4427581
(43) Veröffentlichungstag der Anmeldung: 07.02.1996
(73) Patentinhaber: Balzers und Leybold Deutschland Holding Aktiengesellschaft, 63450 Hanau (DE)
(72) Erfinder: Steiniger, Gerhard, Dipl. Phys., D-63549 Ronneburg (DE); Ludwig, Rainer, Dipl. Phys. Dr., D-63768 Hösbach (DE); Hoffmann, Gerd, Dipl. Ing., D-63486 Bruchköbel (DE)
(74) Vertreter: Schlagwein, Udo, Dipl.-Ing.

(56) Entgegenhaltungen:
- EP-A- 0 324 351
- PATENT ABSTRACTS OF JAPAN vol. 017 no. 216 (C-1053) ,28.April 1993 & JP-A-04 354872 (TOPPAN PRINTING CO LTD) 9.Dezember 1992,
- PATENT ABSTRACTS OF JAPAN vol. 004 no. 077 (C-013) ,4.Juni 1980 & JP-A-55 041959 (SANYO SHINKU KOGYO KK) 25.März 1980,

## Beschreibung

Die Erfindung betrifft ein Verfahren zum Aufbringen einer transparenten Metalloxidschicht auf eine flexible Folie, bei dem in einem Rezipienten ein Metall verdampft und in der Dampfphase mit Sauerstoff in Berührung gebracht wird und bei dem während der Beschichtung mittels optischer Sensoren die sich bildende Metalloxidschicht abgetastet und danach das Verfahren gesteuert wird.

Ein solches Verfahren ist Gegenstand der EP-A-0 324 351. Diese Schrift zeigt eine reaktiv arbeitende Sputteranlage, bei der in einem Rezipienten ein optischer Sensor angeordnet ist, welcher die Transmission der erzeugten Schicht misst danach die Sauerstoffzufuhr der Anlage steuert, um eine gewünschte Transmission der beschichteten Folie zu erreichen.

Reaktives Verdampfen eines Metalles zur Beschichtung eines Substrates wird beispielsweise in der DE-A-36 34 598 beschrieben. Diese Schrift befasst sich jedoch, genau wie die zuvor genannte, nicht mit dem Problem der Regelung der Verdampfungsrate und damit der Erzeugung einer genau festgelegten Schichtdicke.

Die JP-A-55 041959 beschreibt das Sputtern einer ITO-Schicht. Dabei wird zunächst auf ein Substrat eine halbtransparente Schicht erzeugt. Danach wird das Substrat unter Atmosphärenbedingungen auf 300°C erwärmt, wodurch es zu einer Nachoxidation und dadurch zu einer Erhöhung der Transparenz kommen soll. Optische Sensoren zur Steuerung der Schichtdicke werden bei dem Verfahren nach dieser Schrift nicht eingesetzt.

Beim Beschichten von Folien mit Aluminium ist es bekannt. im Rezipienten hinter dem Beschichtungsfenster über die Breite der Folie mehrere optische Sensoren anzuordnen, welche die Transmission bzw. optische Dichte der mit Aluminium beschichteten Folie misst und danach die Leistung und/oder Bewegung des Elektronenstrahls über den Metalltiegel steuert. Beim Beschichten einer Folie mit einem transparenten Material, wie beispielsweise Al₂O₃, ist eine solche Schichtdickenüberwachung jedoch nicht möglich, wenn das beschichtete Material eine hohe Transparenz hat. Das wird beispielsweise für Folien als Verpackung von Lebensmitteln gefordert, damit die Lebensmittel gut zu sehen sind, ihre Farbe nicht durch die Verpackung unvorteilhaft verändert wird und ein Erwärmen des Inhalts einer Verpackung im verpackten Zustand mittels Mikrowellen rasch möglich ist. Bislang misst man die Dicke transparenter Schichten mittels Röntgenstrahlen, was jedoch relativ aufwendig ist.

Der Erfindung liegt das Problem zugrunde, ein Verfahren der eingangs genannten Art zur Aufbringung einer hoch-transparenten Oxidschicht auf eine Folie zu entwickeln, bei dem die Schichtdicke während des Verfahrens auf besonders einfache Weise ermittelt werden kann.

Dieses Problem wird erfindungsgemäß dadurch gelöst, dass in den Rezipienten eine zu keiner ausreichenden Transparenz der Metalloxidschicht führende, leicht unterstöchiometrische Sauerstoffmenge eingegeben und zur Ermittlung der aufgebrachten Schichtdicke und Steuerung der Abdampfrate die optischen Sensoren in einem Bereich angeordnet sind, in dem die Schicht infolge eines Anteils nicht oxidierten Metalls eine für die optische Messung ausreichende Absorption hat und dass nach der Ermittlung der Schichtdicke mittels der optischen Sensoren eine Nachoxidation der Schicht vorgenommen wird.

Durch ein solches Verfahren wird es auch beim Erzeugen hochtransparenter Metalloxidschichten möglich, mit einfachen optischen Sensoren die Schichtdicke inline zu ermitteln und danach die Beschichtungsanlage zu steuern. Der Grundgedanke der Erfindung liegt darin, zunächst keine vollständig transparente Schicht zu erzeugen, damit ein Messen der Schichtdicke über die Transmission bzw. optische Dichte noch möglich wird und die volle, gewünschte Transparenz erst durch ein Nachoxidieren zu verwirklichen. Das Beschichten mit einem unterstöchiometrischen Sauerstoffanteil im Rezipienten hat zusätzlich den Vorteil, daß die unerwünschte Bildung einer porösen Schicht durch einen zu hohen Sauerstoffanteil zuverlässig ausgeschlossen werden kann. In erster Linie wird das erfindungsgemäße Verfahren zur Beschichtung durchsichtiger Folien Anwendung finden. Mit dem optischen Sensor wird dann Licht gemessen, welches die beschichtete Folie durchleuchtet. Es ist jedoch auch möglich, mittels eines Sensors die Reflexion der Beschichtung zu ermitteln. Dann kann das erfindungsgemäße Verfahren auch bei undurchsichtigen Folien Anwendung finden.

Das Nachoxidieren kann auf verschiedene Weise erfolgen. Besonders einfach ist es, wenn gemäß einer vorteilhaften Weiterbildung der Erfindung die Nachoxidation außerhalb des Rezipienten durch den Sauerstoffgehalt der Luft erfolgt. Ein solches Nachoxidieren kann beispielsweise dann erfolgen, wenn man die Folie von einer Vorratsrolle abwickelt und aus ihr Verpackungen formt.

Alternativ ist es jedoch auch möglich, daß die Nachoxidation in einer den optischen Sensoren nachgeordneten Oxidationsstufe erfolgt.

Grundsätzlich ist das erfindungsgemäße Verfahren davon unabhängig, wie das Metall verdampft wird. Wenn zum Verdampfen des Metalls ein über einen Tiegel mit Metall streichender Elektronenstrahl vorgesehen ist, dann ist es vorteilhaft, zur Regelung der Schichtdicke die Leistung des Elektronenstrahls in Abhängigkeit von den Meßwerten des optischen Sensors zu verändern.

Transparente Oxidschichten können aus Oxiden verschiedener Metalle, insbesondere Al, Cr, Si, Sn und Al-Legierungen erzeugt werden. Praktisch erprobt und als besonders vorteilhaft erkannt wurde des Verfahren für die Erzeugung einer Schicht aus Aluminiumoxid.

Die Eigenschaften der Schicht, insbesondere die für Lebensmittelverpackungen wichtige Barrierewirkung gegenüber Sauerstoff und Aromastoffen, sind besonders vorteilhaft, wenn im Rezipienten ein Plasma erzeugt wird. Hierdurch treffen die Metalloxidmoleküle als Ionen mit erhöhter Geschwindigkeit auf die Schicht auf und es kommt zu einer dichteren Schicht.

Das Plasma kann vorteilhafterweise dadurch erzeugt werden, daß in der Dampfwolke Mikrowellenenergie eingekoppelt wird.

Eine gleichmäßige Schichtdicke auch bei breiten Folien läßt sich über ihre gesamte Breite erreichen, wenn gemäß einer anderen Weiterbildung der Erfindung die Absorption der Folie über ihre Breite an mehreren Stellen gemessen wird und aufgrund der Meßwerte die Leistung und/oder die Bewegung des Elektrodenstrahls über einen Tiegel mit dem zu verdampfenden Metall geregelt wird.

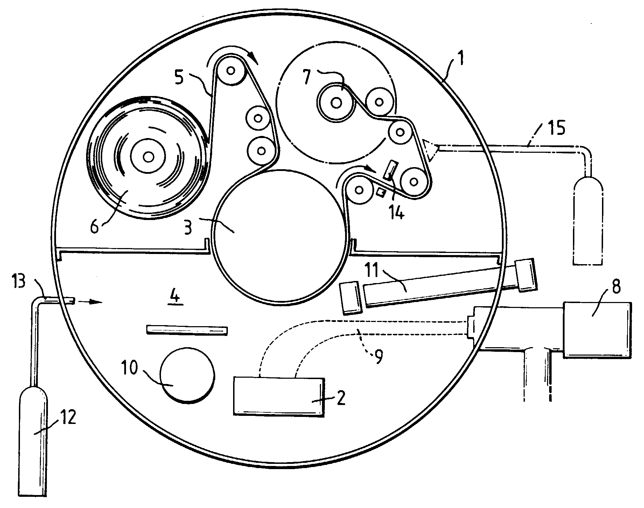

Zur weiteren Verdeutlichung des erfindungsgemäßen Verfahrens wird nachfolgend auf die Zeichnung Bezug genommen, welche einen stark schematischen senkrechten Schnitt durch eine Beschichtungsanlage zur Durchführung des erfindungsgemäßen Verfahrens zeigt.

In der Zeichnung ist ein zylindrischer Rezipient 1 dargestellt, in welchem ein länglicher Tiegel 2 mit Aluminium angeordnet ist. Oberhalb dieses Tiegels 2 ist eine Beschichtungswalze 3 vorgesehen, welche eine Beschichtungskammer 4 nach oben hin begrenzt. Über diese Beschichtungswalze 3 läuft kontinuierlich eine zu beschichtende Folie 5, welche von einer Vorratsrolle 6 abgewickelt und auf eine Aufwickelrolle 7 aufgewickelt wird.

Zum Verdampfen des Metalls im Tiegel 2 dient eine Elektronenstrahlkanone 8, deren Elektronenstrahl 9 durch eine Magnetspule 10 zum Tiegel 2 hin umgelenkt wird. Um in der entstehenden Dampfwolke ein Plasma zu erzeugen, wird mittels einer Hornantenne 11 Mikrowellenenergie in die Beschichtungskammer 4 eingegeben. Da die Folie 5 mit einem Metalloxid beschichtet werden soll, im Tiegel 2 jedoch ein reines Metall verdampft, muß in die Beschichtungskammer 4 Sauerstoff eingegeben werden, was schematisch durch eine Sauerstoffquelle 12 und eine in die Beschichtungskammer 4 hineinführende Sauerstoffleitung 13 angedeutet wurde. Dieser Sauerstoff wird in eine durch Vorversuche ermittelte Menge mittels eines nicht gezeigten Flußreglers mit sehr hoher Konstanz und sehr gleichmäßig eingegeben.

Die Tansmission bzw. optische Dichte der Folie 5 wird durch einen optischen Sensor 14 überwacht, welcher hinter der Beschichtungswalze 3 angeordnet ist. Über die Breite der Folie 5 sind mehrere solcher Sensoren 14 angeordnet. Strichpunktiert dargestellt ist in Bewegungsrichtung hinter dem Sensor 14 eine Oxidationsstufe 15 angedeutet, welche nicht zwingend vorgesehen sein muß und in der Sauerstoff gegen die Folie 5 geblasen werden kann.

Wichtig für die Erfindung ist es, daß die in die Beschichtungskammer 4 eingebrachte Sauerstoffmenge unterstöchiometrisch ist, damit nicht alles Metall oxidiert und deshalb eine völlig transparente Schicht auf der Folie 5 entsteht. Durch diese unterstöchiometrische Zugabe von Sauerstoff hat die Schicht auf der Folie 5 eine ausreichend große Absorption, um mittels der optischen Sensoren 14 über die Breite der Folie 5 aufgrund der Absorption auf die Schichtdicke schließen zu können. Das ermöglicht eine einfache Regelung des Beschichtungsvorganges, indem man bei zu geringer oder zu großer Schichtdicke die Leistung und/oder Wanderbewegung des Elektronenstrahls 9 über die Metalloberfläche im Tiegel 2 verändert.

Praktisch erprobt wurde das erfindungsgemäße Verfahren mit reinem Aluminium als Metall für die Schicht auf einer Kunststoff-Folie. Hierbei hat sich gezeigt, daß die zu einer nahezu völligen Transparenz führende Nachoxidation bei der Verarbeitung der Folie zu Verpackungen von selbst an der Atmosphäre stattfindet, so daß in der Anlage keine Oxidationsstufe erforderlich wird. Zum Erzeugen einer gewünschten Schichtdicke kann man dabei die Absorption der Schicht beispielsweise auf 5 % konstant halten. Nach der Nachoxidation ergibt sich dann eine Absorption der Schicht von unter 1 % bei einer Absorption der unbeschichteten Folie von etwa 10%. Ein sinnvoller Bereich für den Sollwert der Absorption der Schicht liegt zwischen 3 und 20 %. Durch die erfindungsgemäße Nachoxidation ergeben sich dann Absorptionswerte der Schicht von 0 bis 8 %, also nahezu volltransparente Schichten.

### Bezugszeichenliste

- 1: Rezipient
- 2: Tiegel
- 3: Beschichtungswalze
- 4: Beschichtungskammer
- 5: Folie

- 6: Vorratsrolle
- 7: Aufwickelrolle
- 8: Elektronenstrahlkanone
- 9: Elektronenstrahl
- 10: Magnetspule

- 11: Hornantrenne
- 12: Sauerstoffquelle
- 13: Sauerstoffleitung
- 14: Sensor
- 15: Oxidationsstufe

## Patentansprüche

1. Verfahren zum Aufbringen einer transparenten Metalloxidschicht auf eine flexible Folie, bei dem in einem Rezipienten ein Metall verdampft und in der Dampfphase mit Sauerstoff in Berührung gebracht wird und bei dem während der Beschichtung mittels optischer Sensoren die sich bildende Metalloxidschicht abgetastet und danach das Verfahren gesteuert wird, **dadurch gekennzeichnet**, dass in den Rezipienten eine zu keiner ausreichenden Transparenz der Metalloxidschicht führende, leicht unterstöchiometrische Sauerstoffmenge eingegeben und zur Ermittlung der aufgebrachten Schichtdicke und Steuerung der Abdampfrate die optischen Sensoren in einem Bereich angeordnet sind, in dem die Schicht infolge eines Anteils nicht oxidierten Metalls eine für die optische Messung ausreichende Absorption hat und dass nach der Ermittlung der Schichtdicke mittels der optischen Sensoren eine Nachoxidation der Schicht vorgenommen wird.

2. Verfahren nach Anspruch 1, **dadurch gekennzeichnet**, dass die Nachoxidation außerhalb des Rezipienten durch den Sauerstoffgehalt der Luft erfolgt.

3. Verfahren nach Anspruch 1, **dadurch gekennzeichnet**, dass die Nachoxidation in einer den optischen Sensoren nachgeordnete Oxidationsstufe erfolgt.

4. Verfahren nach zumindest einem der vorangehenden Ansprüche, bei dem zum Verdampfen des Metalls ein über einen Tiegel mit Metall streichender Elektronenstrahl vorgesehen ist, **dadurch gekennzeichnet**, dass zur Regelung der Schichtdicke die Leistung des Elektronenstrahls in Abhängigkeit von den Messwerten des optischen Sensors verändert wird.

5. Verfahren nach zumindest einem der vorangehenden Ansprüche, **dadurch gekennzeichnet**, dass das Metall Aluminium ist.

6. Verfahren nach zumindest einem der vorangehenden Ansprüche, **dadurch gekennzeichnet**, dass im Rezipienten ein Plasma erzeugt wird.

7. Verfahren nach zumindest einem der vorangehenden Ansprüche, **dadurch gekennzeichnet**, dass in der Dampfwolke Mikrowellenenergie eingekoppelt wird.

8. Verfahren nach zumindest einem der vorangehenden Ansprüche, **dadurch gekennzeichnet**, dass die Absorption der Folie über ihre Breite an mehreren Stellen gemessen wird und aufgrund der Messwerte die Leistung und/oder die Bewegung des Elektrodenstrahls über einen Tiegel mit dem zu verdampfenden Metall geregelt wird.

## Claims

1. Method for coating a flexible sheet with a transparent metal oxide layer, in which a metal is vaporised in a recipient and brought into contact with oxygen in the vapour phase and in which the metal oxide layer forming is scanned by means of optical sensors during coating and the process is controlled accordingly, **characterised in that** a slightly sub-stoichiometric quantity of oxygen, which does not lead to adequate transparency of the metal oxide layer, is fed into the recipient and, to determine the layer thickness applied and control the rate of vaporisation, the optical sensors are arranged in an area in which the layer has sufficient absorption for optical measurement owing to a proportion of unoxidised metal, and that, after determination of the layer thickness by means of the optical sensors, secondary oxidation of the layer is undertaken.

2. Method according to claim 1, **characterised in that** the secondary oxidation takes place outside the recipient through the oxygen content of the air.

3. Method according to claim 1, **characterised in that** the secondary oxidation takes place in an oxidation step downstream of the optical sensors.

4. Method according to at least one of the above claims, in which an electron beam passing across a crucible with metal is provided to vaporise the metal, **characterised in that** the output of the electron beam is modified as a function of the values measured by the optical sensor in order to regulate the layer thickness.

5. Method according to at least one of the above claims, **characterised in that** the metal is aluminium.

6. Method according to at least one of the above claims, **characterised in that** a plasma is produced in the recipient.

7. Method according to at least one of the above claims, **characterised in that** microwave energy is input in the vapour cloud.

8. Method according to at least one of the above claims, **characterised in that** the absorption of the sheet is measured at several points across its width and the output and/or the movement of the electrode beam across a crucible with the metal to be vaporised is regulated on the basis of the measured values.

## Revendications

1. Procédé pour appliquer une couche transparente d'oxyde métallique sur une feuille flexible, dans lequel un métal est vaporisé dans un récipient et est mis en contact avec de l'oxygène dans la phase vapeur, dans lequel la couche d'oxyde métallique qui se forme pendant le revêtement est surveillée au moyen de détecteurs optiques, le procédé étant piloté sur cette base, caractérisé en ce que l'on introduit dans le récipient une quantité d'oxygène légèrement inférieure à la quantité stoechiométrique, qui ne conduit pas à une transparence suffisante de la couche d'oxyde métallique, en ce que les détecteurs optiques servant à déterminer l'épaisseur de la couche appliquée et à piloter la vitesse de vaporisation sont disposés dans une région dans laquelle la couche présente une absorption suffisante pour la mesure optique suite à la présence d'une teneur en métal non oxydé, et en ce que, après la détermination de l'épaisseur de la couche au moyen des détecteurs optiques, on conduit une post-oxydation de la couche.

2. Procédé selon la revendication 1, caractérisé en ce que la post-oxydation s'effectue par l'oxygène contenu dans l'air, à l'extérieur du récipient.

3. Procédé selon la revendication 1, caractérisé en ce que la post-oxydation s'effectue dans un étage d'oxydation disposé en aval des détecteurs optiques.

4. Procédé selon au moins l'une des revendications précédentes, dans lequel, pour vaporiser le métal, il est prévu un faisceau d'électrons balayant un creuser contenant le métal, caractérisé en ce que pour réguler l'épaisseur de la couche, la puissance du faisceau d'électrons est modifiée en fonction des valeurs de mesure du détecteur optique.

5. Procédé selon au moins l'une des revendications précédentes, caractérisé en ce que le métal est l'aluminium.

6. Procédé selon au moins l'une des revendications précédentes, caractérisé en ce qu'un plasma est créé dans le récipient.

7. Procédé selon au moins l'une des revendications précédentes, caractérisé en ce que de l'énergie micro-ondes est injectée dans le nuage de vapeur.

8. Procédé selon au moins l'une des revendications précédentes, caractérisé en ce que l'on mesure l'absorption de la feuille en plusieurs emplacements répartis sur sa largeur, et en ce que l'on régule sur base des valeurs de mesure la puissance et/ou le déplacement du faisceau d'électrons sur un creuset contenant le métal à vaporiser.
